**Europäisches Patentamt**

**European Patent Office**

**Office européen des brevets**

(19)

(11) Numéro de publication : **0 481 889 A1**

(12) # DEMANDE DE BREVET EUROPEEN

(21) Numéro de dépôt : **91402765.1**

(22) Date de dépôt : **16.10.91**

(51) Int. Cl.⁵ : **H01L 23/485,** H01L 23/50

(30) Priorité : **18.10.90 FR 9012908**

(43) Date de publication de la demande :
**22.04.92 Bulletin 92/17**

(84) Etats contractants désignés :
**DE GB**

(71) Demandeur : **SOCIETE D'APPLICATIONS
GENERALES D'ELECTRICITE ET DE
MECANIQUE SAGEM
6, Avenue d'Iéna
F-75116 Paris (FR)**

(72) Inventeur : **Pradel, Denis
2 rue d'Epluches
F-95480 Pierrelaye (FR)**

(74) Mandataire : **Mongrédien, André et al
c/o BREVATOME 25, rue de Ponthieu
F-75008 Paris (FR)**

(54) **Procédé de réalisation de circuits intégrés à double connectique.**

(57)   Selon l'invention, on réalise deux ou trois séries de plots conducteurs (14, 16, 18) et on dégage en fin de procédé, dans la couche de passivation, la ou les séries désirées.

   Application dans la technique des circuits intégrés.

FIG. 1

La présente invention a pour objet un procédé de réalisation de circuits intégrés à double connectique. Elle trouve une application dans la technique des circuits intégrés et en particulier dans la réalisation de circuits de commande d'écrans d'affichage, notamment à cristaux liquides.

L'intégration des circuits électroniques soulève, entre autres problèmes, celui de la réalisation des connexions électriques entre le circuit intégré et l'extérieur. Cette technique des connexions est connue aujourd'hui sous le nom de connectique. Plus la densité d'intégration augmente, plus le nombre d'entrées/sorties s'élève et plus difficile est le problème de connectique.

On connaît un certain nombre de techniques permettant d'établir de telles connexions et par exemple, la technique dite TAB pour "Tape Automated Bonding" ou liaison automatisée à bande. Elle consiste à former des plots conducteurs répartis autour de la zone active de la puce et reliés aux circuits électroniques implantés dans celle-ci, et à venir souder des pattes conductrices sur ces plots conducteurs.

On peut trouver une description détaillée de cette technique par exemple dans l'ouvrage édité par S.M. SZE et intitulé "VLSI Technology", McGraw-Hill International Book Company.

Dans certains cas, notamment pour les circuits à très forte densité d'intégration, on préfère éviter l'emploi de liaisons intermédiaires et utiliser la technique dite COG pour "Chip On Glass" ou puce sur verre, ou encore COX pour "Chip On X", c'est-à-dire puce sur matériau X. Selon cette technique, on reporte la puce par multiples collages ou brasures obtenues par refusion, directement sur le support en verre (ou en céramique ou en tout autre matériau compatible, y compris les circuits imprimés spéciaux).

Pour un circuit intégré donné, le type de connectique est déterminé par avance et est réalisé au cours du procédé de réalisation du circuit. Les plots métalliques sont réalisés lors des dernières opérations de fabrication, notamment au cours d'une opération de métallisation. Une couche de passivation (en oxydes, nitrures, polyimides ou autre) est ensuite déposée sur l'ensemble et, par gravure, les plots conducteurs sont dégagés pour que les connexions puissent ensuite s'effectuer.

Les applications d'un circuit intégré donné sont donc déterminées non seulement par les fonctions électroniques remplies par ce circuit mais aussi par la connectique qui a été choisie. Il y a là une limitation, dans la mesure où un circuit intégré à fonctions électroniques données pourrait, dans certains cas, servir à d'autres applications s'il présentait une autre connectique (par exemple une connectique COG au lieu d'une connectique TAB).

La présente invention a justement pour but de remédier à cet inconvénient.

A cette fin, l'invention propose un procédé de réalisation qui ménage plusieurs possibilités de connexion jusqu'à la dernière opération, laquelle définit en dernier lieu celle ou celles des variantes retenue(s). Il est alors possible de réaliser des circuits intégrés pouvant servir à des applications différentes et cela avec un seul procédé de fabrication, seule la dernière étape de gravure de la couche de passivation étant spécifique de la connectique finalement choisie. Il en résulte une diminution du coût et des délais de fabrication.

De façon précise, la présente invention a pour objet un procédé de réalisation d'un circuit intégré et de ses moyens de connectique, comprenant des opérations de formation d'une zone active dans la partie centrale d'une puce semi-conductrice et des opérations de formation de plots conducteurs de connexion répartis autour de ladite zone active, ce procédé étant caractérisé par le fait que, par lesdites opérations de formation de plots conducteurs :

– on forme une première série de plots conducteurs à la périphérie de la puce, ces plots ayant une structure adaptée à la technologie de type "liaison automatisée à bande", dite encore "TAB",

– on forme une deuxième série de plots conducteurs entre la première série et la zone centrale de la puce, ces plots ayant une structure adaptée aux technologies de type "puce sur verre" ou "puce sur matériau X", dites encore "COG" ou "COX",

– on recouvre l'ensemble de la puce d'une couche de passivation,

– on grave cette couche de passivation pour dégager l'une au moins des deux séries de plots conducteurs, selon la connectique finalement désirée.

Selon l'invention, on peut dégager soit les plots TAB, soit les plots COG (ou COX), soit à la fois les plots TAB et les plots COG (ou COX).

Dans une variante avantageuse pour éviter toute dégradation des plots TAB ou COX, on forme également une troisième série de plots conducteurs ayant une structure adaptée à la technique de test sous pointes, la gravure de la couche de passivation dégageant ainsi l'une au moins des trois séries de plots. La troisième série de plots n'est pas dégagée si l'on a effectué le test sous pointes avant passivation et est dégagée si l'on doit effectuer le test sous pointes après passivation.

De toute façon, les caractéristiques et avantages de l'invention apparaîtront mieux à la lumière de la description qui va suivre, d'un exemple de réalisation donné à titre explicatif et nullement limitatif. Cette description se réfère à des dessins annexés sur lesquels :

– la figure 1 montre schématiquement, en vue de dessus, un circuit intégré réalisé selon le procédé de l'invention ;

– la figure 2 illustre schématiquement la dernière étape du procédé selon l'invention.

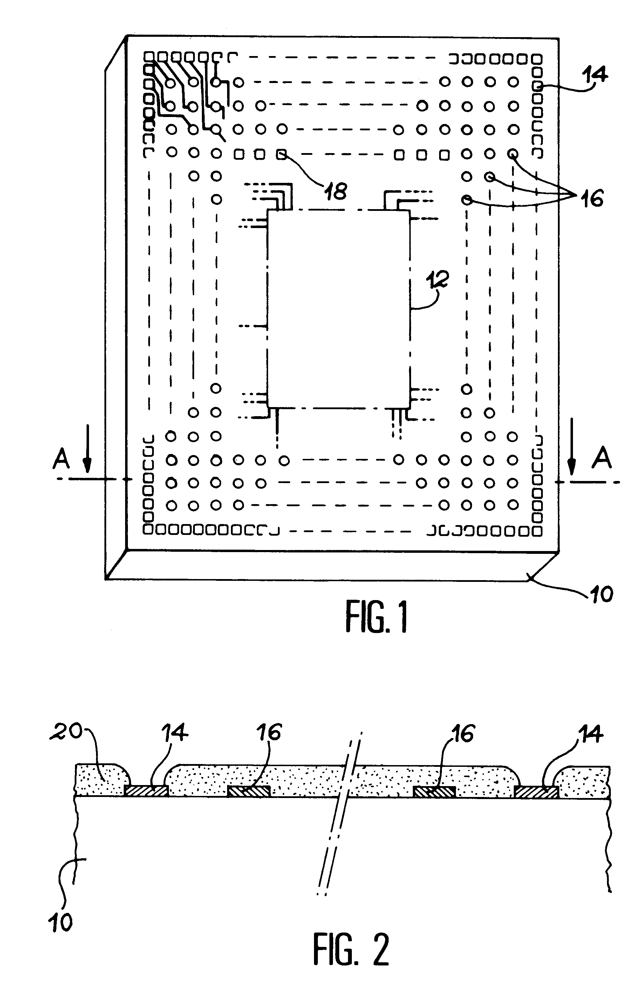

Il va de soi que, pour plus de clarté, les dessins annexés ne sont pas à l'échelle. On voit, tout d'abord, sur la figure 1, une puce 10 de forme rectangulaire (ou éventuellement carrée) comprenant, dans sa partie centrale, une zone active 12 où sont implantés les circuits. On trouve à la périphérie de la puce une rangée 14 de plots TAB, et, disposés entre la rangée 14 et le circuit 12, des rangées (par exemple trois) de plots COG (ou COX) référencés 16. Enfin, un alignement de plots 18 est prévu pour test sous pointes. Cette troisième série peut occuper l'un des côtés de la puce.

Les plots de la rangée 14 sont reliés aux plots des rangées 16 par des lignes conductrices non représentées, si ce n'est, et de manière très schématique, dans le coin supérieur gauche de la figure 1.

Sur la figure 2, qui correspond à une coupe le long d'une rangée de plots COG, on voit, en outre, la couche de passivation 20 qui, dans le cas illustré, a été gravée uniquement à l'endroit des plots TAB 14 (les plots COG 16 n'ayant pas été dégagés).

**Revendications**

1. Procédé de réalisation de circuits intégrés et de leurs moyens de connectique, comprenant des opérations de formation d'une zone active (12) dans la partie centrale d'une puce semi-conductrice (10) et des opérations de formation de plots conducteurs de connexion répartis autour de ladite zone active (12), ce procédé étant caractérisé par le fait que, par lesdites opérations de formation des plots conducteurs :

   – on forme une première série (14) de plots conducteurs à la périphérie de la puce, ces plots ayant une structure adaptée à la technologie de type "liaison automatisée à bande" dite encore TAB,

   – on forme une deuxième série (16) de plots conducteurs entre la première série (14) et la zone centrale (12) de la puce, cette deuxième série ayant une structure adaptée aux technologies de type "puce sur verre" ou "puce sur autre matériau", dites encore "COG" ou "COX",

   – on recouvre l'ensemble de la puce d'une couche de passivation (20),

   – on grave cette couche de passivation (20) pour dégager l'une au moins des deux séries de plots conducteurs (14, 16) selon la connectique finalement désirée.

2. Procédé selon la revendication 1, caractérisé par le fait que l'on forme également une troisième série (18) de plots conducteurs ayant une structure adaptée à la technique de test sous pointes, la gravure de la couche de passivation (20) dégageant ainsi l'une au moins des trois séries (14, 16, 18) de plots, la troisième série (18) de plots n'étant pas dégagée si l'on a effectué un test sous pointes avant passivation et étant dégagée si l'on a effectué le test sous pointes après passivation.

3. Procédé selon la revendication 1, caractérisé par le fait qu'on réalise la première série (14) de plots conducteurs sous forme d'une rangée rectangulaire de plots disposée à la périphérie de la puce.

4. Procédé selon la revendication 3, caractérisé par le fait qu'on réalise la deuxième série (16) de plots conducteurs sous forme de plusieurs rangées rectangulaires de plots, ces rangées étant inscrites à l'intérieur de la rangée constituant la première série (14) de plots conducteurs.

5. Procédé selon la revendication 2, caractérisé par le fait qu'on réalise la troisième série (18) de plots de test sous forme d'une rangée de plots disposée le long d'un ou de plusieurs des côtés du circuit (12).

FIG. 1

FIG. 2

Office européen
des brevets

**RAPPORT DE RECHERCHE EUROPEENNE**

Numéro de la demande

EP 91 40 2765

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| A | US-A-4 860 087 (MATSUBARA)<br>* colonne 1, ligne 9 - ligne 65 *<br>* colonne 3, ligne 35 - ligne 48 *<br>* colonne 5, ligne 61 - colonne 6, ligne 49 *<br>* colonne 7, ligne 19 - ligne 24 *<br>* colonne 10, ligne 57 - colonne 11, ligne 11 *<br>--- | 1 | H01L23/485<br>H01L23/50 |
| A | 36TH ELECTRONIC COMPONENTS CONF.<br>Mai 1986, SEATTLE, E-U<br>pages 53 - 58;<br>RICHARD LANDIS: 'Alternative bonding methods for chip on board technology'<br>* Page 54, Section intitulé "Flip Chip Bonding"*<br>* page 57 *<br>--- | 1 | |
| A | PATENT ABSTRACTS OF JAPAN<br>vol. 9, no. 288 (E-358)(2011) 15 Novembre 1985<br>& JP-A-60 130 153 11 Juillet 1985<br>* abrégé *<br>--- | 2 | |
| P,A | EP-A-0 402 592 (TOSHIBA)<br>* colonne 5, ligne 10 - ligne 29 *<br><br>----- | 1 | **DOMAINES TECHNIQUES RECHERCHES (Int. Cl.5 )**<br><br>H01L |

Le présent rapport a été établi pour toutes les revendications

| Lieu de la recherche | Date d'achèvement de la recherche | Examinateur |
|---|---|---|
| LA HAYE | 02 JANVIER 1992 | GREENE S.K. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)